# FASCICULE DE BREVET EUROPEEN

(11) **EP 3 481 167 B1**
(45) Date de publication et mention de la délivrance du brevet: **11.03.2020**
(21) Numéro de dépôt: 18204125.1
(22) Date de dépôt: 02.11.2018
(51) Int. Cl.: H05K 7/14

(54) **RACK POUR MODULES ÉLECTRONIQUES, ARMOIRE COMPRENANT UN TEL RACK, ET VÉHICULE ÉQUIPÉ D'UN TEL RACK**
RACK FÜR ELEKTRONISCHE MODULE, SCHALTSCHRANK, DER EIN SOLCHES RACK UMFASST, UND FAHRZEUG, DAS MIT EINEM SOLCHEN RACK AUSGESTATTET IST
RACK FOR ELECTRONIC MODULES, CABINET COMPRISING SUCH A RACK AND VEHICLE EQUIPPED WITH SUCH A RACK

(30) Priorité: 03.11.2017 FR 1760351
(43) Date de publication de la demande: 08.05.2019
(73) Titulaire: ALSTOM Transport Technologies, 93400 Saint-Ouen (FR)
(72) Inventeur: ZANETTI, Adrien, 69100 VILLEURBANNE (FR); BLANCHET, Damien, 01150 BLYES (FR)
(74) Mandataire: Lavoix

(56) Documents cités:
- EP-A1- 1 111 978
- DE-U1- 9 010 410
- US-A- 5 375 724
- US-A1- 2004 257 776
- US-B1- 6 447 082

## Description

La présente invention concerne un rack (ou tiroir) destiné à recevoir des modules électroniques tels que des cartes électroniques, et prévu généralement pour être monté dans une armoire électronique (ou baie électronique), par exemple une armoire électronique d'un véhicule, en particulier un véhicule ferroviaire.

Il est possible de prévoir un rack comprenant une structure délimitant un logement pour la réception de modules électroniques, la structure étant formée de deux panneaux latéraux espacés transversalement et de poutres transversales s'étendant transversalement entre les deux panneaux latéraux.

Il est possible de munir un tel rack d'un insert taraudé se présentant sous la forme d'une barrette allongée possédant une série d'orifices taraudés prévus le long de la barrette, l'insert taraudé étant logé dans une rainure ménagée dans une poutre transversale et s'étendant le long de celle-ci (voir par exemple EP 1 111 978 ou US 5 375 724). Un tel insert taraudé permet de fixer des modules électroniques reçus dans le rack par vissage dans des orifices taraudés de l'insert taraudé.

Un tel insert taraudé peut être très sollicité mécaniquement lors du montage et du démontage des modules électroniques. Il est possible que le taraudage d'un orifice taraudé de l'insert taraudé s'use ou qu'une vis de fixation d'un module électronique casse dans un orifice taraudé, ce qui nécessite de changer l'insert taraudé.

La rainure recevant l'insert taraudé débouche à une extrémité de la poutre. L'insert taraudé est monté sur la poutre transversale correspondante en étant inséré dans la rainure à partir d'une extrémité de la poutre transversale, en faisant coulisser l'insert taraudé dans la rainure.

Pour démonter un insert taraudé défectueux, il convient de démonter un panneau latéral du rack électronique afin de dégager l'extrémité de la poutre transversale recevant l'insert, puis d'extraire l'insert défectueux par cette extrémité de la poutre transversale. Un nouvel insert taraudé peut être inséré dans la poutre transversale avant de remonter le panneau latéral. Ceci est contraignant car cela demande relativement beaucoup de main-d'œuvre et cela ne facilite pas la maintenance des racks.

Un des buts de l'invention est de proposer un rack dont la maintenance soit plus facile, et par conséquent moins coûteuse.

A cet effet, l'invention propose un rack configuré pour recevoir des modules électroniques, par exemple des cartes électroniques, le rack comprenant une structure formée de deux panneaux latéraux espacés suivant une direction transversale et de poutres transversales s'étendant entre les deux panneaux latéraux, les poutres transversales incluant au moins une poutre transversale possédant une rainure s'étendant le long de la poutre transversale et recevant un insert taraudé possédant une pluralité d'orifices taraudés pour la fixation de modules électroniques sur la poutre transversale par vissage, le rack comprenant un système de montage possédant une ouverture ménagée dans un panneau latéral et permettant l'extraction de l'insert taraudé par coulissement dans la rainure et passage à travers l'ouverture, le système de montage étant configuré de sorte qu'à l'état opérationnel du rack, l'insert taraudé est bloqué dans la rainure sans pouvoir sortir par l'ouverture.

L'ouverture ménagée dans le panneau latéral permet d'extraire l'insert taraudé de la rainure par une extrémité de la poutre transversale en faisant coulisser l'insert taraudé dans la rainure tout en le faisant passer à travers l'ouverture. Il n'est donc pas nécessaire de démonter complètement le panneau latéral pour extraire un insert défectueux et remonter un insert non défectueux. La configuration du système de montage assurant un blocage de l'insert taraudé évite que l'insert taraudé ne sorte involontairement par l'ouverture.

Selon des exemples de réalisation particuliers, le rack peut comprendre une ou plusieurs des caractéristiques optionnelles suivantes, prises isolément ou selon toutes les combinaisons techniquement possibles :
- l'ouverture est décalée par rapport à l'insert taraudé reçu dans la rainure, de façon que l'insert taraudé interfère avec un bord périphérique de l'ouverture en cas de coulissement de l'insert taraudé dans la rainure, un déplacement ou une déformation élastique de la poutre transversale après démontage ou desserrage d'une fixation de la poutre sur le panneau latérale permettant d'amener l'insert taraudé en regard de l'ouverture pour permettre son passage à travers l'ouverture ;
- la poutre transversale est fixée sur le panneau latérale par une fixation par vissage comprenant au moins une vis de fixation, par exemple deux vis de fixation ;
- le système de montage comprend une vis de blocage vissée dans un orifice taraudé de l'insert taraudé de manière à coopérer pour empêcher le coulissement de l'insert taraudé dans la rainure ;
- la vis de blocage prend appui sur un fond de la rainure et maintien l'insert taraudé en appui contre des épaulements internes de la rainure ;
- le système de montage est configuré pour empêcher l'insert taraudé de sortir par l'ouverture en l'absence de module électronique fixé sur l'insert taraudé ;
- le rack est configuré pour l'insertion de modules électroniques par coulissement suivant une direction longitudinale ;
- le système de montage est configuré de manière à permettre de faire passer l'insert taraudé à travers l'ouverture après desserrage ou démontage d'au moins une vis, par exemple une vis de fixation de la poutre transversale sur le panneau latéral portant l'ouverture ou une vis de blocage vissée dans un orifice taraudé de l'insert taraudé de manière à bloquer l'insert taraudé dans la rainure.

L'invention concerne également une armoire électronique comprenant au moins un rack tel que défini ci-dessus.

L'invention concerne encore un véhicule, par exemple véhicule ferroviaire, comprenant un rack (tel que défini ci-dessus ou une armoire électronique tel que définie ci-dessus.

L'invention et ses avantages seront mieux compris à la lecture de la description qui va suivre, donnée uniquement à titre d'exemple, et faite en référence aux dessins annexés, sur lesquels :
- la Figure 1 est une vue en perspective d'un rack prévu pour recevoir des modules électroniques ;
- la Figure 2 est une vue de côté partielle du rack illustrant un système de montage d'un insert taraudé, selon un exemple de réalisation ;
- la Figure 3 est une vue analogue à celle de la Figure 2 illustrant un système de montage selon un autre exemple de réalisation.

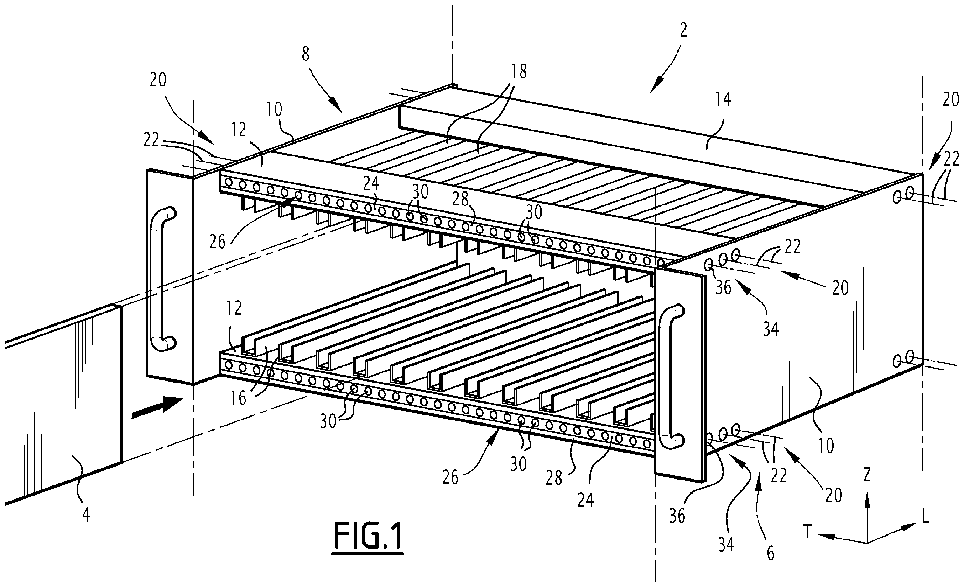

Le rack 2 illustré sur la Figure 1 est prévu pour recevoir une pluralité de modules électroniques 4. Un module électronique 4 est par exemple une carte électronique. Un module électronique 4 est représenté sur le Figure 1.

Le rack 2 est destiné à être inséré dans une armoire électronique 6. Une telle armoire électronique est généralement propre à recevoir plusieurs racks. Une armoire électronique 6 est illustrée schématiquement en pointillés sur la Figure 1.

Le rack 2 possède une structure 8 comprenant deux panneaux latéraux 10 espacés suivant une direction transversale T, et des poutres transversales 12, 14 s'étendant transversalement entre les panneaux latéraux 10. Chaque poutre transversale 12, 14 s'étend suivant la direction transversale T. Chaque poutre transversale 12, 14 est par exemple prévue sous la forme d'un profilé.

Les poutres transversales 12, 14 incluent par exemple deux poutres transversales 12 avant et deux poutres transversales 14 arrière, une seule poutre transversale 14 arrière étant visible sur la Figure 1.

Les deux poutres transversales 12 avant sont espacées verticalement, suivant une direction verticale Z, pour l'insertion des modules électroniques 4 entre les deux poutres transversales 12 avant.

Le rack 2 est par exemple configuré pour le montage des modules électroniques 4 à l'intérieur du rack 2 par insertion de chaque module électronique 2 suivant une direction longitudinale L.

Le rack 2 comprend ici des rails de montage 16, 18 fixés sur les poutres transversales 12, 14. Les rails de montage 16 s'étendant suivant la direction longitudinale L, pour permettre le montage des modules électroniques 4 à l'intérieur du rack 2.

Plus précisément, le rack 2 comprend des rails de montage 16 supérieurs et des rails de montage 18 inférieurs, chaque rail de montage 16 inférieur étant associé un rail de montage 18 supérieur pour le guidage d'un module électronique 4.

Chaque poutre transversale 12, 14 est reçue entre les deux panneaux latéraux 10. Chaque extrémité de chaque poutre transversale 12, 14 est en appui contre une face interne d'un panneau latéral 10 respectif, ladite face interne étant tournée vers l'autre panneau latéral 10.

L'extrémité de chaque poutre transversale 12, 14 est fixée aux panneaux latéraux 10 par une fixation 20 par vissage comprenant au moins une vis de fixation 22 vissée dans une extrémité de la poutre transversale 12, 14 à travers le panneau latéral 10. Les les vis de fixation 22 sont schématisées par des traits mixtes sur la Figure 1.

Les poutres transversales 12, 14 incluent au moins une poutre transversale 12 munie d'un insert taraudé 24 reçu dans une rainure 26 ménagée dans la poutre transversale 12 avant.

La rainure 26 s'étend le long de la poutre transversale 12 avant. La rainure 26 débouche sur le côté de la poutre transversale 12 avant par une fente 28 s'étendant le long de la poutre transversale 12 avant.

L'insert taraudé 24 se présente sous la forme d'une barre ou barrette allongée munie d'une série d'orifices taraudés 30 répartis le long de l'insert taraudé 24.

Lorsque l'insert taraudé 24 est logé dans la rainure 26 d'une poutre transversale 12, il est possible de visser des vis dans les orifices taraudés 30 à travers la fente 28, par exemple pour fixer des modules électroniques sur la poutre transversale 12.

Dans l'exemple illustré, chaque poutre transversale 12 avant est munie d'un insert taraudé 24 reçu dans une rainure 26 de cette poutre transversale 12 avant.

Les poutres transversale 12 munies d'un insert taraudé 24 et leur montage dans la structure 8 sont analogues. Par la suite, on s'intéresse à la poutre transversale 12 avant supérieure.

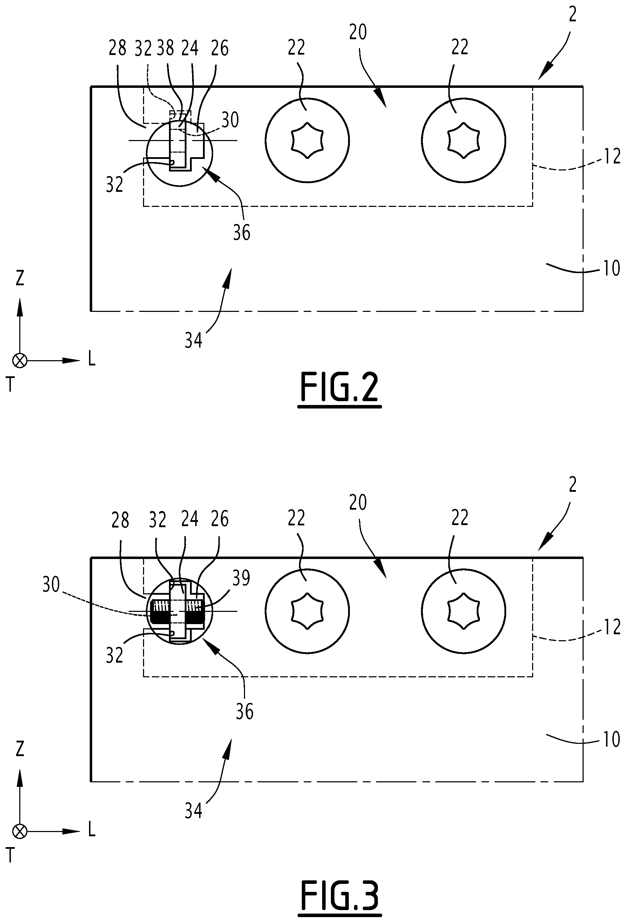

Comme cela est visible sur la Figure 2, sur laquelle la poutre transversale 12 munie d'un insert taraudé 24 est visible en vue en bout, l'insert taraudé 24 et la rainure 26 sont configurés de sorte que l'insert taraudé 24 ne peut sortir de la rainure 26 à travers la fente 28. L'insert taraudé 24 présente une largeur telle qu'il vient en appui sur des épaulements internes 32 de la rainure 26 situés de part et d'autre de la fente 28.

La rainure 26 de la poutre transversale 12 débouche à l'extrémité de la poutre transversale 12 adjacente au panneau latéral 10 visible sur la Figure 2.

Lorsque la poutre transversale 12 est démontée de la structure 8, l'insert taraudé 24 peut coulisser dans la rainure 26 pour insérer ou extraire l'insert taraudé à partir de cette extrémité de la poutre transversale 12.

Comme visible sur la Figure 2, le rack 2 comprend un système de montage 34 configuré pour le montage et le démontage d'un insert taraudé 24 reçu dans une rainure 26 d'une poutre transversale 12 sans avoir à démonter la poutre transversale 12 ou le panneau latéral 10.

Le système de montage 34 possède une ouverture 36 ménagée dans le panneau latéral 10 et configurée pour permettre l'extraction et l'insertion de l'insert taraudé 24 dans la rainure 26 par l'extrémité de la poutre transversale 12, à travers cette ouverture 36.

L'ouverture 36 est dimensionnée pour permettre le passage de l'insert taraudé 24 à travers cette ouverture 36.

Le système de montage 34 est en outre configuré pour le blocage de l'insert taraudé 24 à l'intérieur de la rainure 26, afin d'éviter que l'insert taraudé 24 ne puisse sortir involontairement par l'ouverture 36, en particulier en l'absence de module électronique 4 fixé sur l'insert taraudé 24.

Dans l'exemple de réalisation de la Figure 2, à l'état opérationnel (ou état monté) de la structure 8, l'ouverture 36 est décalée par rapport à l'insert taraudé 24 reçu dans la rainure 26, de sorte que l'insert taraudé 24 interfère avec un bord périphérique 38 de l'ouverture 36 et ne peut coulisser à travers l'ouverture 36.

Cependant, l'ouverture 36 est disposée de manière que, après desserrage ou démontage de la fixation 20 reliant l'extrémité de la poutre transversale 12 au panneau latéral 10, il est possible de décaler l'extrémité par rapport à l'ouverture par déplacement et/ou déformation élastique de la poutre transversale 12 pour placer l'insert taraudé 24 en regard de l'ouverture 36 et permettre le passage de l'insert taraudé 24 à travers l'ouverture 36.

L'état opérationnel ou l'état monté désigne un état dans lequel la structure 8 est montée et prête à être utilisée. Les différents éléments de la structure 8 sont fixés les uns aux autres de manière appropriée. En particulier, les fixations par vis sont serrées.

L'état opérationnel ou état monté s'oppose à un état démonté dans lequel au moins une fixation entre des éléments de la structure est partiellement ou complètement démontée, en particulier par desserrage ou retrait d'au moins une vis de fixation.

Dans l'exemple illustré, la poutre transversale 12 est fixée sur le panneau latéral 10 par une fixation 20 à vis de fixation 22. Le desserrage d'au moins une ou de chaque vis de fixation 22 (pour desserrer la fixation 20) ou le retrait de chaque vis de fixation 22 (pour libérer l'extrémité de la poutre transversale 12 du panneau latéral 10) permet de déplacer ou de déformer élastiquement la poutre transversale 12 pour placer l'insert taraudé 24 en regard de l'ouverture 36 et permettre son passage à travers celle-ci.

Ainsi, il est possible d'insérer ou d'extraire l'insert taraudé 24 sans avoir à démonter l'ensemble du panneau latéral 10, mais simplement en démontant ou en desserrant la fixation 20 de l'extrémité de la poutre transversale 12 reliée au panneau latéral 10 muni de l'ouverture 36.

Lorsque la fixation 20 est desserrée ou démontée, on considère que la structure 8 n'est pas dans un état monté, mais dans un état desserré ou partiellement démonté.

De préférence, le décalage de l'extrémité de la poutre transversale 12 est possible sans desserrer ou sans démonter l'autre extrémité de la poutre transversale 12 fixée sur l'autre panneau latéral 10.

Pendant l'extraction de l'insert taraudé, l'autre extrémité de la poutre transversale peut rester fixée à l'autre panneau latéral. Il s'ensuit que les opérations de maintenance sont plus faciles et plus rapides à réaliser.

Dans l'exemple de réalisation de la Figure 3, à l'état monté de la structure 8, l'ouverture 36 est alignée avec l'insert taraudé 24 reçu dans la rainure 26 de sorte que, l'insert taraudé 24 peut passer par l'ouverture 26 lors du coulissement de l'insert taraudé 24 dans la rainure 26.

Cependant, le système de montage 34 comprend une vis de blocage 39 vissée dans un orifice taraudé 30 de l'insert taraudé 24, l'élément de blocage 39 prenant appui sur un fond 40 de la rainure 26 et poussant l'insert taraudé 24 en appui contre les épaulements internes 30 de la rainure 26 situés de part et d'autre de la fente 28.

Ainsi, l'insert taraudé 24 est bloqué en coulissement dans la rainure 26 par friction ou adhérence, ici entre l'insert taraudé 24 et les épaulements internes 32.

Pour extraire l'insert taraudé 24 de la rainure 26, l'opérateur doit desserrer ou retirer la vis de blocage 39 avant de faire coulisser l'insert taraudé 24 par l'ouverture 36.

Dans ce mode de réalisation, il n'est pas nécessaire de desserrer ou libérer la fixation 20 de l'extrémité de la poutre transversale 12 fixée sur le panneau latéral 10.

La vis de blocage 39 ne sert pas à la fixation d'un module électronique 4 reçu dans le rack 2 sur la poutre transversale 12.

La vis de blocage 39 est notamment ici configurée pour assurer à elle seule le blocage en coulissement de l'insert taraudé 24, sans nécessiter un élément d'appui rapporté en appui sur la poutre transversale 12 à l'extérieur de la rainure 26. La vis de blocage 39 est ici configurée pour prendre appui sur la rainure 26.

Dans un exemple de réalisation, la vis de blocage 39 est configurée pour passer à travers l'ouverture 36. Ainsi, il n'est pas nécessaire de retirer la vis de blocage 39 de l'insert taraudé 24 pour faire passer l'insert taraudé 24 à travers l'ouverture 36.

En variante, la vis de blocage 39 est configurée pour interférer avec l'ouverture lorsqu'elle est vissée dans un orifice taraudé 30 de l'insert taraudé 24. La vis de blocage 39 est par exemple trop longue pour passer à travers l'ouverture 36 lorsqu'elle est vissée dans un orifice taraudé 30 de l'insert taraudé 24.

Dans cette variante, il convient d'extraire la vis de blocage 39 de l'orifice taraudé 30 dans lequel elle est engagée avant de faire passer l'insert taraudé 24 par l'ouverture 36.

Dans l'exemple illustré, la poutre transversale 12 avant inférieure et la poutre transversale 12 avant supérieure sont chacune munies d'un insert taraudé 24 logé dans une rainure 26 de la poutre transversale 12, au moins un des deux panneaux latéraux étant muni d'une ouverture 36 pour le passage de l'insert taraudé 24.

En variante, une seule des poutres transversales 12 avant est munie d'un insert taraudé 24.

Lorsqu'une poutre transversale 12 est munie d'un insert taraudé 24, il est possible de prévoir une ouverture 36 associé à cette poutre transversale 12 sur un seul des deux panneaux latéraux 10 entre lesquels s'étend la poutre transversale 12, ou sur chacun des deux panneaux latéraux 10 entre lesquels s'étend la poutre transversale 12. Le montage/démontage de l'insert taraudé 24 est alors possible respectivement à travers un seul des deux panneaux latéraux 10 ou à travers chaque panneau latéral 10.

On notera que dans les exemples de réalisation décrits, le système de montage 34 est configuré de manière à permettre de faire passer l'insert taraudé 24 à travers l'ouverture 36 après desserrage ou démontage d'au moins une vis, par exemple une vis de fixation de la poutre transversale sur le panneau latéral 10 portant l'ouverture 36 ou une vis de blocage 39 vissée dans un orifice taraudé de l'insert taraudé 24 de manière à bloquer l'insert taraudé 24 dans le rainure 26.

En particulier, le système de montage 34 est configuré de manière à permettre de faire passer l'insert taraudé 24 à travers l'ouverture 36 après desserrage ou démontage d'exactement une vis ou d'exactement deux vis, par exemple une vis de fixation 22 de la poutre transversale sur le panneau latéral 10 portant l'ouverture 36, deux vis de fixation 22 de la poutre transversale sur le panneau latéral 10 portant l'ouverture 36 ou une vis de blocage 39 vissée dans un orifice taraudé de l'insert taraudé 24 de manière à bloquer l'insert taraudé 24 dans le rainure 26.

Les exemples de réalisation des Figures 2 et 3 ont été décrits comme des alternatives. Il est possible de combiner ces deux exemples de réalisation, en prévoyant à la fois une ouverture 36 décalée par rapport à l'insert à l'état monté de la structure 8, et une vis de blocage 39.

Un exemple de réalisation combinant ceux des Figures 2 et 3 permettrait de faire coulisser l'insert taraudé 24 à travers l'ouverture 36 après desserrage ou dévissage d'exactement deux vis (une vis de fixation 22 et une vis de blocage 39) ou d'exactement trois vis (deux vis de fixation 22 et une vis de blocage 39).

## Revendications

1. Rack configuré pour recevoir des modules électroniques (4), par exemple des cartes électroniques, le rack comprenant une structure (8) formée de deux panneaux latéraux (10) espacés suivant une direction transversale (T) et de poutres transversales (12, 14) s'étendant entre les deux panneaux latéraux (10), les poutres transversales (12, 14) incluant au moins une poutre transversale (12) possédant une rainure (26) s'étendant le long de la poutre transversale (12) et recevant un insert taraudé (24) possédant une pluralité d'orifices taraudés (30) pour la fixation de modules électroniques (4) sur la poutre transversale (12) par vissage, le rack comprenant un système de montage (34) possédant une ouverture (36) ménagée dans un panneau latéral (10) et permettant l'extraction de l'insert taraudé (24) par coulissement dans la rainure (26) et passage à travers l'ouverture (36), le système de montage (34) étant configuré de sorte qu'à l'état opérationnel du rack, l'insert taraudé (34) est bloqué dans la rainure (26) sans pouvoir sortir par l'ouverture (36).

2. Rack selon la revendication 1, dans lequel l'ouverture (36) est décalée par rapport à l'insert taraudé (24) reçu dans la rainure (26), de façon que l'insert taraudé (24) interfère avec un bord périphérique (38) de l'ouverture (36) en cas de coulissement de l'insert taraudé (24) dans la rainure (26), un déplacement ou une déformation élastique de la poutre transversale (12) après démontage ou desserrage d'une fixation de la poutre sur le panneau latéral (10) permettant d'amener l'insert taraudé (24) en regard de l'ouverture (36) pour permettre son passage à travers l'ouverture (36).

3. Rack selon la revendication 1 ou 2, dans lequel la poutre transversale (12) est fixée sur le panneau latéral (10) par une fixation (20) par vissage comprenant au moins une vis de fixation (22), par exemple deux vis de fixation (22).

4. Rack selon l'une quelconque des revendications précédentes, dans lequel le système de montage (34) comprend une vis de blocage (39) vissée dans un orifice taraudé (30) de l'insert taraudé (24) de manière à coopérer pour empêcher le coulissement de l'insert taraudé (24) dans la rainure (26).

5. Rack selon la revendication 4, dans lequel la vis de blocage (39) prend appui sur un fond de la rainure (26) et maintien l'insert taraudé (24) en appui contre des épaulements internes de la rainure (26).

6. Rack selon l'une quelconque des revendications précédentes, dans lequel le système de montage (34) est configuré pour empêcher l'insert taraudé (24) de sortir par l'ouverture (36) en l'absence de module électronique (4) fixé sur l'insert taraudé.

7. Rack selon l'une quelconque des revendications précédentes, configuré pour l'insertion de modules électroniques (4) par coulissement suivant une direction longitudinale (L).

8. Rack selon l'une quelconque des revendications précédentes, dans lequel le système de montage (34) est configuré de manière à permettre de faire passer l'insert taraudé (24) à travers l'ouverture (36) après desserrage ou démontage d'au moins une vis, par exemple une vis de fixation de la poutre transversale sur le panneau latéral (10) portant l'ouverture (36) ou une vis de blocage (39) vissée dans un orifice taraudé de l'insert taraudé (24) de manière à bloquer l'insert taraudé (24) dans la rainure (26).

9. Armoire électronique comprenant au moins un rack selon l'une quelconque des revendications 1 à 8.

10. Véhicule, par exemple véhicule ferroviaire, comprenant un rack (2) selon l'une quelconque des revendications 1 à 8 ou une armoire électronique (6) selon la revendication 9.

## Patentansprüche

1. Baugruppenträger, welcher eingerichtet ist zum Aufnehmen von Elektronikmodulen (4), beispielsweise von Elektronikkarten, wobei der Baugruppenträger eine Struktur (8) aufweist, welche gebildet ist aus zwei seitlichen Paneelen (10), welche entlang einer transversalen Richtung (T) im Abstand sind, und aus transversalen Trägern (12, 14), welche sich zwischen den beiden seitlichen Paneelen (10) erstrecken, wobei die transversalen Träger (12, 14) aufweisen mindestens einen transversalen Träger (12), welcher eine Nut (26) aufweist, welche sich entlang des transversalen Trägers (12) erstreckt und einen Gewindeeinsatz (24) aufnimmt, welcher eine Mehrzahl von Gewindeöffnungen (30) für die Befestigung von Elektronikmodulen (4) an dem transversalen Träger (12) mittels Schraubens hat, wobei der Baugruppenträger ein System zum Montieren (34) aufweist, welches eine Öffnung (36) hat, welche in dem seitlichen Paneel (10) herbeigeführt ist und das Extrahieren des Gewindeeinsatzes (24) mittels Verschiebens in der Nut (26) und einen Durchgang durch die Öffnung (36) erlaubt, wobei das System zum Montieren (34) eingerichtet ist, sodass im Betriebszustand des Baugruppenträgers der Gewindeeinsatz (34) in der Nut (26) blockiert ist, ohne mittels der Öffnung (36) hinausgelangen zu können.

2. Baugruppenträger gemäß Anspruch 1, wobei die Öffnung (36) bezüglich des Gewindeeinsatzes (24), welcher in der Nut (26) aufgenommen ist, versetzt ist, sodass der Gewindeeinsatz (24) mit einem Umfangsrand (38) der Öffnung (36) zusammenwirkt im Fall des Verschiebens des Gewindeeinsatzes (24) in der Nut (26), wobei ein Bewegen oder ein elastisches Deformieren des transversalen Trägers (12) nach dem Demontieren oder Lockern einer Befestigung des Trägers an dem lateralen Paneel (10) erlaubt, den Gewindeeinsatz (24) gegenüber der Öffnung (36) zu bringen, um seinen Durchgang durch die Öffnung (36) zu erlauben.

3. Baugruppenträger gemäß Anspruch 1 oder 2, wobei der transversale Träger (12) an dem lateralen Paneel (10) befestigt ist mittels einer Befestigung (20) mittels Schraubens, welche mindestens eine Befestigungsschraube (22), zum Beispiel zwei Befestigungsschrauben (22), aufweist.

4. Baugruppenträger gemäß irgendeinem der vorherigen Ansprüche, wobei das System zum Montieren (34) eine Blockierschraube (39) aufweist, welche in eine Gewindeöffnung (30) des Gewindeeinsatzes (24) geschraubt ist, um zu kooperieren, um das Verschieben des Gewindeeinsatzes (24) in der Nut (26) zu verhindern.

5. Baugruppenträger gemäß Anspruch 4, wobei die Blockierschraube (39) auf einem Boden der Nut (26) aufliegt und den Gewindeeinsatz (24) in Abstützung gegen innere Schultern der Nut (26) hält.

6. Baugruppenträger gemäß irgendeinem der vorherigen Ansprüche, wobei das System zum Montieren (34) eingerichtet ist, um zu verhindern, dass der Gewindeeinsatz (24) mittels der Öffnung (36) in der Abwesenheit des Elektronikmoduls (4), welches an dem Gewindeeinsatz befestigt ist, hinausgelangt.

7. Baugruppenträger gemäß irgendeinem der vorherigen Ansprüche, welcher eingerichtet ist zum Einführen von Elektronikmodulen (4) mittels Verschiebens entlang einer longitudinalen Richtung (L).

8. Baugruppenträger gemäß irgendeinem der vorherigen Ansprüche, wobei das System zum Montieren (34) eingerichtet ist, um es zu erlauben, den Gewindeeinsatz (24) durch die Öffnung (36) passieren zu lassen nach dem Lockern oder Demontieren von mindestens einer Schraube, zum Beispiel einer Befestigungsschraube des transversalen Trägers an dem seitlichen Paneel (10), welches die Öffnung (36) hat, oder einer Blockierschraube (39), welche in eine Gewindeöffnung des Gewindeeinsatzes (24) geschraubt ist, um den Gewindeeinsatz (24) in der Nut (26) zu blockieren.

9. Elektronikschrank, welcher mindestens einen Baugruppenträger gemäß irgendeinem der Ansprüche 1 bis 8 aufweist.

10. Fahrzeug, zum Beispiel Schienenfahrzeug, welches mindestens einen Baugruppenträger (2) gemäß irgendeinem der Ansprüche 1 bis 8 oder einen Elektronikschrank (6) gemäß Anspruch 9 aufweist.

## Claims

1. Rack configured to receive electronic modules (4), for example printed circuit boards, the rack comprising a structure (8) formed from two spaced lateral panels (10) according to a transverse direction (T) and from transverse beams (12, 14) extending between the two lateral panels (10), the transverse beams (12, 14) including at least one transverse beam (12) having a groove (26) extending along the transverse beam (12) and receiving a threaded insert (24) having a plurality of threaded openings (30) for fixing electronic modules (4) on the transverse beam (12) by screwing, the rack comprising an assembly system (34) having an opening (36) provided in a lateral panel (10) and allowing extraction of the threaded insert (24) by sliding in the groove (26) and passage through the opening (36), the assembly system (34) being configured so that, in the operational state of the rack, the threaded insert (34) is locked in the groove (26) without being able to leave via the opening (36).

2. Rack according to claim 1, in which the opening (36) is offset relative to the threaded insert (24) received in the groove (26), such that the threaded insert (24) interferes with a peripheral edge (38) of the opening (36) in the case of sliding of the threaded insert (24) in the groove (26), a displacement or an elastic deformation of the transverse beam (12) after dismantling or unscrewing of a fixing of the beam on the lateral panel (10) making it possible to move the threaded insert (24) opposite the opening (36) in order to allow its passage through the opening (36).

3. Rack according to claim 1 or 2, in which the transverse beam (12) is fixed on the lateral panel (10) by fixing (20) by screwing comprising at least one fixing screw (22), for example two fixing screws (22).

4. Rack according to any of the preceding claims, in which the assembly system (34) comprises a locking screw (39) screwed into a threaded opening (30) of the threaded insert (24) so as to cooperate in order to prevent sliding of the threaded insert (24) in the groove (26).

5. Rack according to claim 4, in which the locking screw (39) abuts on a base of the groove (26) and keeps the threaded insert (24) abutting against the internal shoulders of the groove (26).

6. Rack according to any of the preceding claims, in which the assembly system (34) is configured to prevent the threaded insert (24) from leaving via the opening (36) in the absence of an electronic module (4) fixed on the threaded insert.

7. Rack according to any of the preceding claims, configured for insertion of electronic modules (4) by sliding according to a longitudinal direction (L).

8. Rack according to any of the preceding claims, in which the assembly system (34) is configured so as to make it possible for the threaded insert (24) to pass through the opening (36) after unscrewing or dismantling of at least one screw, for example a screw for fixing the transverse beam on the lateral panel (10) carrying the opening (36) or a locking screw (39) screwed into a threaded opening of the threaded insert (24) so as to lock the threaded insert (24) in the groove (26).

9. Electronics cabinet comprising at least one rack according to any of the claims 1 to 8.

10. Vehicle, for example railway vehicle, comprising a rack (2) according to any of the claims 1 to 8 or an electronics cabinet (6) according to claim 9.
